# EUROPEAN PATENT APPLICATION

(11) **EP 2 911 213 A1**
(43) Date of publication of application: **26.08.2015**
(21) Application number: 14156379.1
(22) Date of filing: 24.02.2014
(51) Int. Cl.: H01L 51/52, H01L 27/32, H01L 51/56, H01L 51/00

(54) **Method of and apparatus for manufacturing a flexible electronic device**

(71) Applicant: Nederlandse Organisatie voor toegepast- natuurwetenschappelijk onderzoek TNO, 2595 DA 's-Gravenhage (NL); IMEC VZW, 3001 Leuven (BE)
(72) Inventor: Gelinck, Gerwin Hermanus, 2628 VK Delft (NL); van der Putten, Bas, 2628 VK Delft (NL)
(74) Representative: Jansen, Cornelis Marinus

(57) **Abstract**

The invention relates to a method of manufacturing a flexible electronic device. The method comprises: providing an adhesive layer onto a rigid support plate; forming the flexible electronic device on the rigid support plate and releasing the electronic device from the rigid support. The flexible electronic device comprises an organic light emitting diode, and the adhesive layer comprises a layer of nickel. The step of releasing the electronic device comprises immersing the rigid support plate including the flexible electronic device in water such as to allow the water to penetrate into the nickel layer for releasing the flexible electronic device. The invention further relates to an apparatus for manufacturing a flexible electronic device, and to an electronic device manufactured using the method or apparatus described.

## Description

The invention relates to a method of manufacturing a flexible electronic device, the method comprising the steps of providing an adhesive layer onto a rigid support plate; forming the flexible electronic device on the rigid support plate and releasing the electronic device from the rigid support. The invention further relates to an apparatus for performing the method, and to a flexible electronic device manufactured with the method or apparatus mentioned above.

The subject matter of the invention is directed at the production of flexible electronics, such as OLEDs for flexible displays. During production, these devices are made using a rigid glass support plate to which the devices are temporarily fixed. Eventually, the devices are to be released from the support plate.

The temporarily fixing of the displays is conventionally achieved by means of gluing. Dependent on the specifics of the glue, various mechanical and optical release methods may be applied to remove the device from the rigid glass substrate. The use of glue and the delamination method have various disadvantages, such as the method being relatively slow, the risk of damaging of the device during release, and the temperature instability of the glue itself, which for example puts restrictions on the maximum processing temperatures for the layers stacked on top thereof.

Various alternative of the conventional gluing methods have been suggested. Most of these suffer more or less from the same disadvantages mentioned above, or focus on overcoming one of the disadvantages at the cost of other disadvantages. For example, to overcome the above disadvantages, local gluing of the device to the glass support plate has been suggested. However, the local gluing leads to a deteriorated fixation of the device to the support plate, which occasionally gives rise to premature release of the device during manufacturing thereof.

It is therefore an object of the present invention to provide a manufacturing method that overcomes the abovementioned disadvantages, and that allows to manufacture flexible electronic devices while these are well and safely fixed to a rigid support, and which can be released easily without damage to the device.

This and other objects are achieved by the present invention in that there is provided a method of manufacturing a flexible electronic device, the method comprising the steps of: providing an adhesive layer onto a rigid support plate; forming the flexible electronic device on the rigid support plate by: providing a flexible substrate layer on the rigid support plate such as to fix the flexible substrate to the rigid support plate using the adhesive layer; and providing one or more device layers onto the flexible substrate layer, such as to form said flexible electronic device comprising at least the flexible substrate layer and the one or more device layers; and the method further comprising a step of releasing the electronic device from the rigid support; wherein the flexible electronic device comprises an organic light emitting diode, and wherein the adhesive layer comprises a layer of nickel, and wherein the step of forming of the flexible electronic device comprises interposing of the flexible electronic device between a first and a second water protection layer; and the step of releasing the electronic device comprises immersing the rigid support plate including the flexible electronic device in water such as to allow the water to penetrate into the nickel layer for releasing the flexible electronic device.

The invention is based on the insight that in order to enable industrialization of many types of flexible electronic devices developed over the past few years, the manufacturing method of such devices requires rethinking. A good example of this may be in the field of active matrix organic light emitting diodes. While many research groups have been successful in fabricating prototypes of active matrix organic light emitting diode displays on flexible substrates before, those efforts have required substantial modifications of existing processes or materials. Because of this, none of the proposed methods is brought to the scale of mass production. Active-matrix displays are traditionally made on rigid glass substrates. Therefore most proposed methods for making flexible displays rely on temporarily bonding of a flexible substrate to the rigid glass carrier. The flexible substrate can be laminated using a glue. Alternatively, the flexible substrate can be spun on the mother glass substrate. In all cases, a release method is needed. During release and after release the display performance needs to be preserved.

The present invention provides for a water mediated release method. As will be appreciated, the use of plain water for effectively and quickly releasing the flexible devices from the rigid support plate effectively deals with the abovementioned disadvantages of the prior art release methods. The rigid support plate is preferably a glass support plate. The nickel layer, at the Ni-_{SiOx} interface, forms an NiO-SiO bonding layer which is released easily in water. Therefore, the flexible display can be released from the glass substrate by submerging the package (substrate + device) in water.

The method of the present invention provides a convenient release method, which additionally takes into account that electronic devices are highly prone to water. Additional measures to allow the release method to be applied to flexible electronic displays containing organic light emitting diodes (OLEDs), such as active matrix organic light emitting diodes (AMOLEDs) used for producing flexible displays, have therefore been included in the method of the present invention. In accordance herewith, the step of forming of the flexible electronic device comprises a step of interposing of the flexible electronic device between a first and a second water protection layer. These water protection layers effectively seal the flexible electronic device from its exterior environment, allowing immersion of the rigid support plate including the electronic device in water.

The step of interposing the flexible electronic device between the first and the second water protection layer may be implemented as follows. Prior to the step of providing the flexible substrate layer, a first water protection layer may be provided on the rigid support plate fixed thereto by means of the adhesive layer. Subsequent to the forming of the electronic device, the second water protection layer may be deposited on the flexible electronic device such as to cover the device. The first water protection layer may be directly deposited on top of the adhesive layer, although additional layers may optionally be interposed between the first water protection layer and the nickel layer. For example, an optional polyimide layer (PI layer) may additionally be added in between the first water protection layer and the nickel layer as an additional carrier.

The primary function of the first and second water protection layer is to prevent any water from reaching the electronic device containing the OLED. A flexible electronic device is therewith protected against water during the step of immersing. Additionally it is also, at any time during manufacturing or thereafter, protected against moist or water from the environment. The method of the present invention thus provides for the manufacturing of robust flexible electronic devices. As will be appreciated, this benefits their use in portable applications, such as mobile phones or tablet type computers. Mobile phones, for example, may during their lifetime be exposed to all kinds of weather conditions - thus a flexible display for use in a mobile phone benefits from the additional water protection layers.

In accordance with a particular embodiment, a water protection layer such as the first and second water protection layer mentioned above, may be provided comprising two or more water barrier layers. A water barrier layer provides a layer which is designed to be impenetrable to water. A water barrier layer may for example be comprised of a layer of silicon nitride (SiNₓ), SiO₂, Al₂O₃ or AlOₓNₓ. In the present embodiment, the water protection layer comprises two (or more) SiNₓ water barrier layers to provide a sufficient protection against water penetration. Using for example a water barrier layer of silicon nitride, it is known that such layers may comprise pinholes. Therefore, a single water barrier layer of silicon nitride may not provide sufficient protection against an attraction of water to the flexible electronic device. By stacking two (or more) water barrier layers on top of each other to provide the water protection layer (i.e. the first or the second or both water protection layers), it is achieved that any pinholes that may be present in the stacked water barrier layers do not add up (coincide) such as to provide a water leak. The flexible electronic device can therefore be effectively protected.

In even a further embodiment, at least one or both of the first and second water protection layers are provided comprising an absorption layer interposed between these two water barrier layers. In this embodiment, the use of two stacked water barrier layers not only effectively reduces the risk of coinciding pinholes, but additionally the absorption layer causes any water that would inadvertently penetrate a first water barrier layer of the water protection layer will become trapped in the absorption layer to protect the flexible electronic device effectively from water. The absorption layer could be made of any suitable material, and may have additional functionality for example to increase light outcoupling, or smoothen the surface roughness such as to provide better quality subsequent layers. Examples are for instance CaO nanoparticles, zeolites, molecular getters.

In accordance with a preferred embodiment of the present invention, the first and the second water protection layers are provided comprising a peripheral extension area extending beyond an area wherein the flexible electronic device is interposed between the water protection layers for sealing the electronic device between the water protection layers. The flexible electronic device does not extend in between the first and second water protection layers between the peripheral extension areas of both water protection layers. For example in the peripheral extension area, the water barrier layers of the first and second water protection layers may be deposited on top of each other such as to be stacked contiguously to seal the electronic device.

In accordance with a yet further embodiment of the present invention, the peripheral extension area extends beyond the nickel layer on the rigid support plate, such as to seal the nickel layer during said manufacturing. In this embodiment, the peripheral extension area does provides additional protection against penetrating water during manufacturing of the flexible electronic device. As a result of the peripheral extension areas which extend across the area of where the nickel layer is deposited on the rigid support plate, also the nickel layer itself is sealed from the environment. This prevents the water to penetrate the nickel layer prematurely, thereby preventing premature release and loss of the flexible electronic device during manufacturing.

Moreover, as a further advantage it enables to keep the flexible display on the rigid support plate after manufacturing, such that it may be transported or stored for later use. During storage, transport or other handling, the water protection layers with the peripheral extension areas will keep the package including all its layers (rigid support plate, adhesion layer, flexible electronic device including water protection layers) fixed. The package is thereby protected against damage.

When the flexible electronic device is ready to be installed, the flexible electronic device may be easily removed from the rigid support plate by cutting or breaking part of the peripheral extension area. Therefore, in accordance with a further embodiment the step of releasing the flexible electronic device from the rigid support plate comprises, prior to said immersing, breaking the water protection layers in the peripheral extension areas such as to provide access to the nickel layer for allowing the water to penetrate the nickel layer during said immersing. The cutting or breaking creates a leak through the peripheral extension area to the nickel layer underneath. Then the package can be immersed in water such as to allow the water to penetrate the nickel layer, thereby releasing the flexible electronic device. As will be appreciated, due to the fact that the present release method is a water mediated release method, releasing of the flexible display can be easily performed anywhere where there is access to water.

The absorption layer mentioned above is provided such as to interpose between the water barrier layers in an area enclosed by the peripheral extension areas. The absorption layer does not extend within the peripheral extension areas between the water barrier layers. The water barrier layers of the first and second water protection layers are contiguous in the peripheral extension areas such as to seal the absorption layer from any cutting or breaking in the peripheral extension areas.

The method may be applied for manufacturing any type of flexible electronic device. The method is particularly beneficial for manufacturing electronic devices that are prone to water, and must be prevented from being in contact with water. As an example already provided above, the method of the present invention would be particularly useful in the manufacturing of active matrix organic light emitting diodes (AMOLEDs). In accordance with a second aspect of the present invention there is provided an apparatus for manufacturing a flexible electronic device using a method according to any of the previous claims, comprising a layer deposition stage for providing an adhesive layer onto a rigid support plate, the adhesive layer comprising a nickel layer; a device manufacturing stage for forming the flexible electronic device on the rigid support plate by depositing a first water protection layer onto the rigid support plate fixed using the adhesive layer, depositing a flexible substrate layer on the first water protection layer, forming one or more device layers onto the flexible substrate layer, and depositing a second water protection layer covering the one or more device layers; and a device release stage for removing the electronic device from the rigid support, wherein device release stage comprises an immersion bath for immersing the rigid support plate including the flexible electronic device in water such as to allow the water to penetrate into the nickel layer for releasing the flexible electronic device.

In accordance with a third aspect of the present invention, there is provided a flexible electronic device manufactured using the method in accordance with a first aspect or manufactured using an apparatus in accordance with a second aspect. This flexible electronic device may for example be an active matrix organic light emitting diode (AMOLED).

### Brief description of the drawing

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figure 1 schematically illustrates a stacked configuration of a flexible electronic device during manufacturing in accordance with a method of the present invention;
Figures 2A-2L schematically illustrate the consecutive deposition of layers and the release method in accordance with an embodiment of the present invention;
Figure 3 schematically illustrates a method of the present invention.

### Detailed description

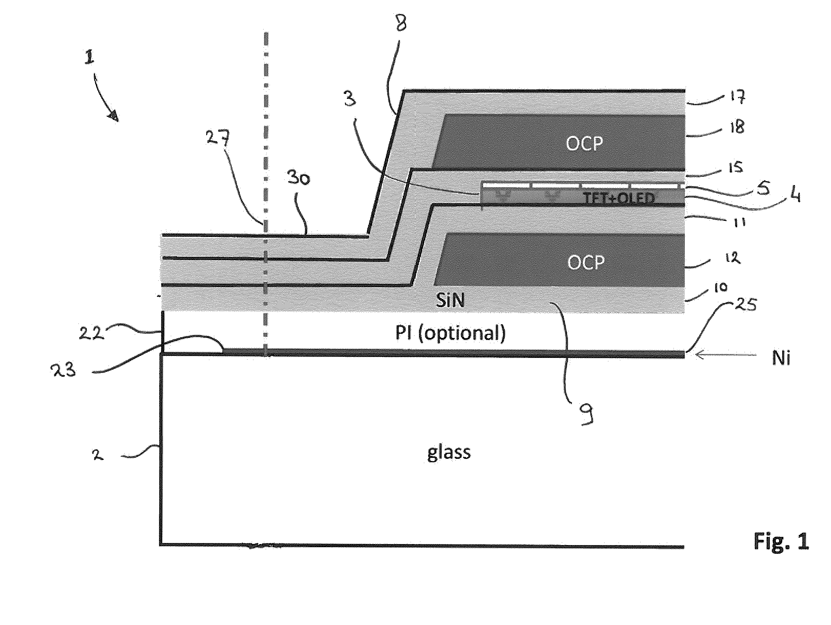

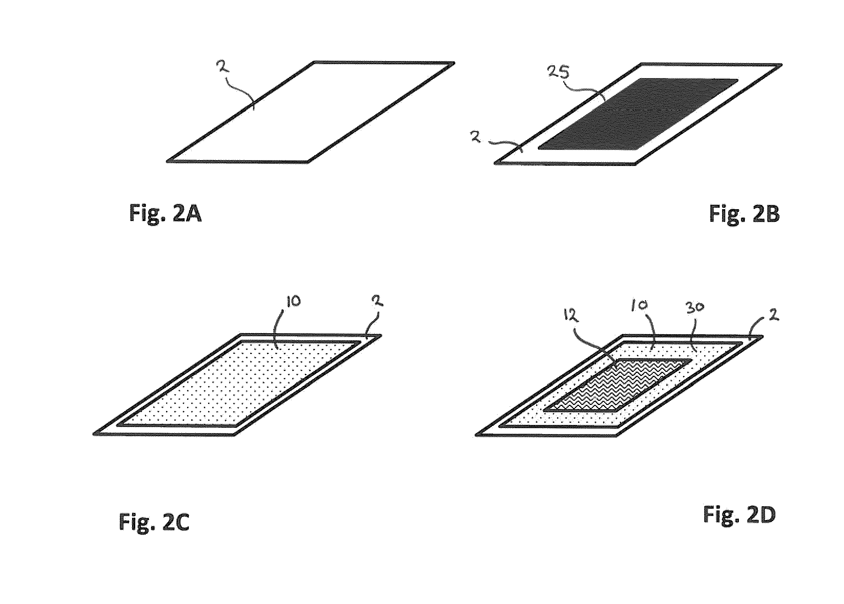

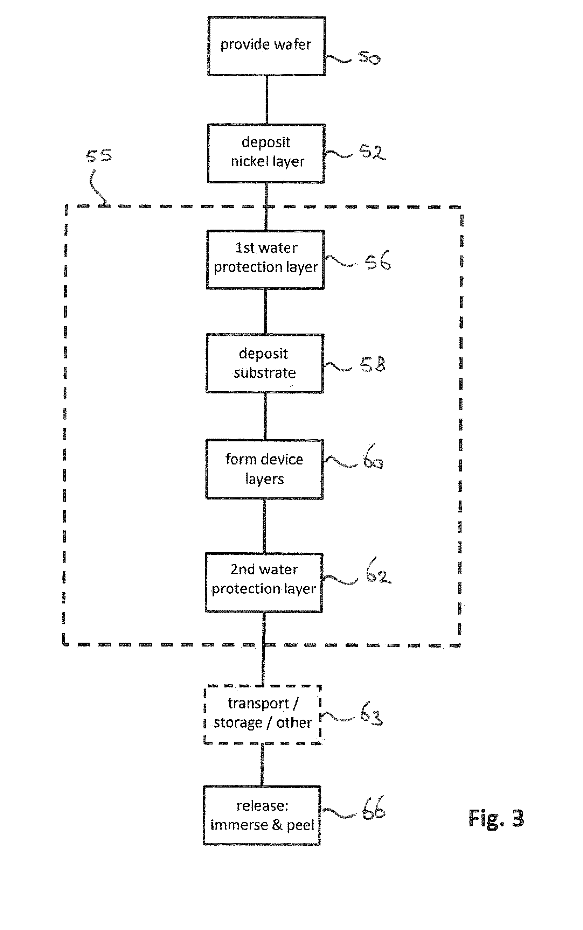

Figure 1 schematically illustrates a stack 1 of layers during a manufacturing method in accordance with the present invention for manufacturing a flexible electronic device. The consecutive steps performed in a method in accordance with an embodiment of the present invention are also illustrated in figures 2A-2L. A more schematic illustration is provided in figure 3. The flexible electronic device 3 is manufactured making use of a rigid support plate 2. The rigid support plate 2 may for example be a glass or ceramic wafer. The use of a glass wafer is advantageous because this allows the wafer to be cleaned and recycled after each use thereof in a manufacturing method. In figure 2A, a glass rigid support plate 2 is provided as a first step of the method, corresponding with step 50 of figure 3.

In accordance with step 52 of figure 3 and schematically illustrated in figure 2B, on top of the glass wafer 2, across apart of its surface, a thin layer of nickel is deposited. The thickness of the nickel layer may be smaller than 1 µm, and typically 10-100nm. The nickel layer 25, at the nickel-glass interface (Ni-SiO₂), will form a NiO-SiO bonding layer with the rigid support plate 2. Such a bonding layer provides a relatively strong fixation while at the same time it is dissolvable in water. Optionally, a polyimide (PI) substrate layer 22 may be deposited on top of the nickel layer 25 as illustrated in figure 1. This PI layer is optional and may be omitted; the embodiment illustrated in figures 2A-2L does not contain such an optional PI layer.

In case no PI layer 22 is desired, the method continues with the forming of the flexible electronic device, in figure 3 illustrated as step 55 as a dotted box. The step of forming of the flexible electronic device consists of a number of consecutive steps. The forming of the flexible electronic device includes steps for protecting the electronic device against water, steps for providing structural integrity to the device, and steps for forming the device itself. In figure 3 the step 55 of forming the flexible electronic device consists of the consecutive steps of providing a first water protection layer (step 56), depositing a flexible substrate layer (step 58), forming the device layers (step 60), and providing a second water protection layer (step 62). The steps 56, 58, 60 and 62 are schematically illustrated in figures 2C-2I.

Before describing each of the steps 56, 58, 60 and 62, a further description of the consecutive layers of the stack 1 illustrated in figure 1 is provided herewith. As illustrated in figure 1 on top of the optional PI layer 22, the first water protection layer 9 consists of two water barrier layers 10 and 11 in between which an absorption layer 12 is interposed. The water barrier layers 10 and 11 may for example comprise a silicon nitride SiN layer. The thickness of each water barrier 10 and 11 may be in the range of 50-300 nm. Such water barrier layers are known to be impenetrable to water, however occasionally these layers may comprise pinholes (not shown) that could form a leak in the water barrier layer. By using two consecutive water barrier layers 10 and 11, for example made of SiN, the occurrence of a leak through the two layers 10 and 11 is effectively prevented. This is due to the fact that there is only limited chance that the pinholes in the water barrier layers 10 and 11 coincide. The risk of the occurrence of a leak is therefore effectively reduced by preventing that pinholes in the two layers 10 and 11 add up to form a leak.

As an additional matter, as illustrated in figure 1, the first water protection layer 9 may comprise an absorption layer 12 interposed in between the barrier layers 10 and 11. The absorption layer 12 ensures that if water would leak through the outer water barrier layer 10, it will remain stored in the absorption layer 12 such as to prevent further leakage to the flexible electronic device 3. In figure 1, the absorption layer 12 is indicated as an organic coating for planarization (OCP) layer. This naming refers to the further function of the OCP layer for smoothening the surface of the carrier for enabling the further water barrier layer 11 to be of higher quality. The OCP layer may comprise any suitable material, for example: polyacrylates.

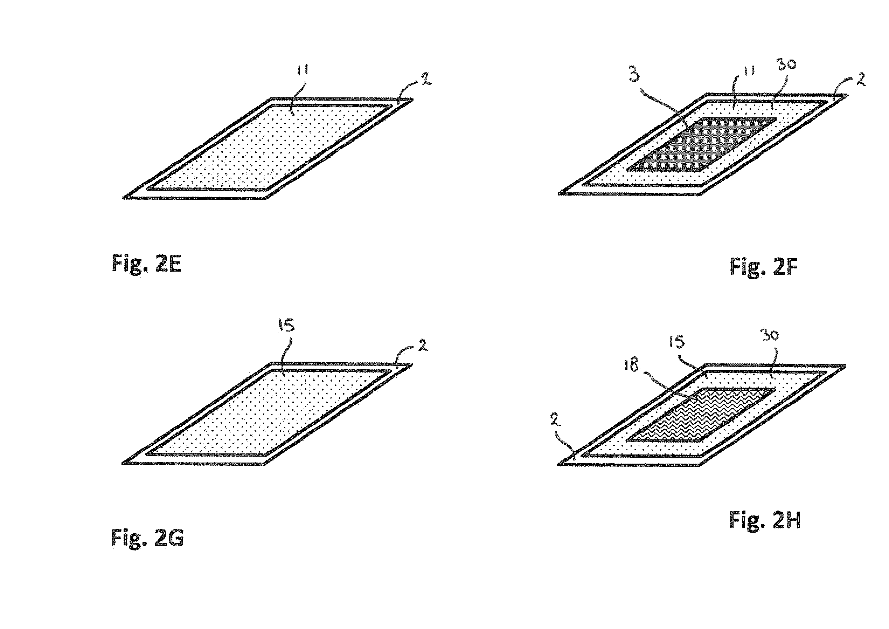

In view of the above, step 56 of providing the first water protection layer, as illustrated in figure 3, consists of a number of consecutive substeps that are illustrated in figures 2C, 2D and 2E. In figure 2C, the first water barrier layer 10 of the first water protection layer 9 is deposited on top of the nickel layer 25 (or, if present, on the optional PI layer 22). Then, as illustrated in figure 2D, the absorption layer 12 (OCP layer) is deposited on a part of the surface of layer 10. The OCP layer or absorption layer 12 extends across the surface of layer 10 in the center part thereof, leaving a peripheral extension area 30 uncovered. The peripheral extension area 30 extends circumferentially to the absorption layer 12 surrounding the absorption layer 12.

The peripheral extension area 30 is a functional strip that is used in the manufacturing method of the present invention. The peripheral extension area 30 (also illustrated in figure 1) serves a number of different functions. During manufacturing, and prior to release of the flexible electronic device 3, the peripheral extension area 30 covers and seals the nickel adhesion layer 25. This prevents water from penetrating the nickel layer 25 prematurely, and releasing the stack 1 prematurely during manufacturing of the flexible electronic device 3. In addition, once the flexible electronic device 3 is ready to be released or removed from the rigid support plate 2, the peripheral extension area 30 serves as a cutting strip that allows an engineer or operator to safely break or cut the peripheral extension area 30 such as to provide access to the adhesive layer 25. After cutting and immersing the package in a bath of water, the cut strip allows easy peeling of the package 40 from the wafer 2, without needing to touch or hold the package 40 in the center part where the flexible electronic device 3 resides. Moreover, the peripheral extension area 30 also seals the flexible electronic device 3 and the absorption layers 12 and 18 of the first and second water protection layers 9 and 8.

The different functions of the peripheral extension area 30 are explained with reference to the illustration of figure 1. In figure 1, it can be seen that in the peripheral extension area 30, the water barrier layers 10, 11 of the first water protection layer 9, and the water barrier layers 15 and 17 of the second water protection layer 8 are contiguously arranged on top of each other in the peripheral extension area 30. This arrangement causes the absorption layers 12 and 18 to be sealed around the periphery thereof. Moreover, the peripheral extension areas 30 extend on the glass wafer 2 beyond the edges 23 of the nickel absorption layer 25. Thereby, it is ensured that also the nickel adhesion layer 25 is sealed from water or moist during manufacturing of the flexible electronic device 3. Lastly, the dotted line 27 indicates an optional position for an engineer to cut through the peripheral extension area 30 such as to expose the nickel absorption layer 25 to water during emerging of the stack 1 in water for releasing the flexible electronic device 3. The part to the right of dashed line 27 and to the left of the absorption layers 12 and 18 may be used as peeling area after water has penetrated and at least partly dissolved the nickel layer 25.

Next, as illustrated in figure 2E, after depositing of the absorption layer 12, the water protection layer 9 is finished by deposition of the further water barrier layer 11 on the surface. Step 56 of figure 3 is therewith finalized. As will be appreciated, in case more than two water barrier layers are desired, any of the steps illustrated in figure 2C and 2E may be repeated for creating additional layers.

The next step in figure 3 is the depositing of a substrate in step 58, and the forming of device layers 60. As will be appreciated by the skilled person, the exact steps taken in the substeps generally indicated with 58 and 60 will be dependent on the type of flexible electronic device to be formed. The method of the present invention may advantageously be applied for the manufacturing of AMOLEDs or other devices comprising OLEDs, but may as well be applied for manufacturing other types of electronic devices. Therefore, in figure 2F, the steps 58 and 60 are simply summarized by illustrating the flexible electronic device 3 being formed on top of the further water barrier layer 11 of the first water protection layer 9. The details of how to obtain the desired flexible electronic device and which device layers to apply, are herewith assumed to be known by the skilled person. With reference to the above, the flexible electronic device 3 will not extend into the peripheral extension areas 30, but will be safely interposed between the first and second water protection layer 9 and 8 in the center part thereof. In figure 1 it is illustrated that the flexible electronic device may consist of a substrate layer 4 and device layers 5. The exact layout of the flexible electronic device 3 is dependent on the type of device being produced.

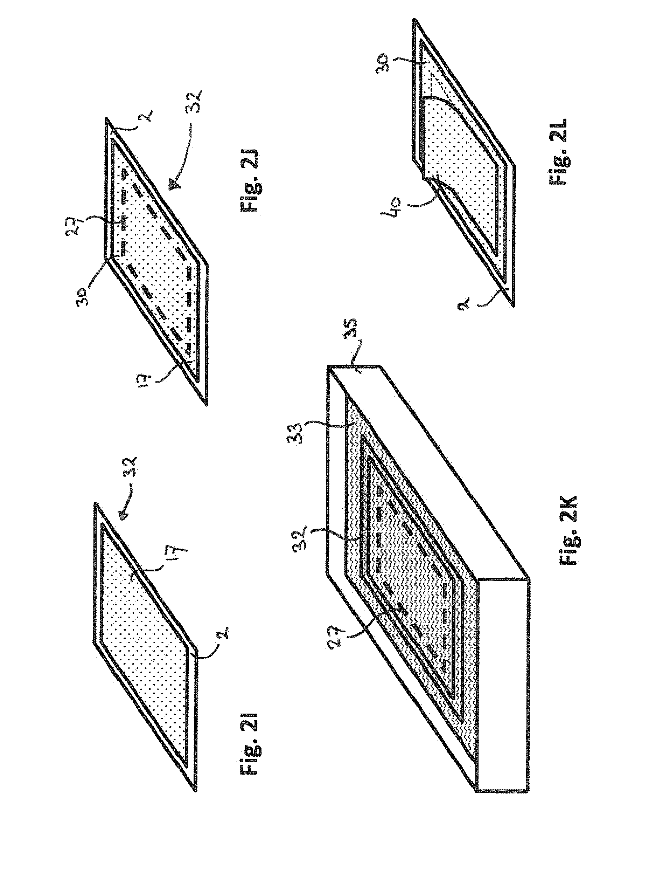

In step 62 of figure 3, the second water protection layer 8 illustrated in figure 1 is provided. Reference is made to figures 2G, 2H, and 2I that illustrate the possible substeps performed for providing the second water protection layer 8. In figure 2G, the first water barrier layer 15 of the second water protection layer 8 is deposited on top of the stack, covering also the peripheral extension areas 30. Then in figure 2H, similar to the step illustrated in figure 2D, an absorption layer 18 is deposited on top of the first water barrier layer 15 in the center part thereof. The absorption layer 18 may be made of the same materials as the absorption layer 12, i.e. an organic coating for planarization (OCP). The absorption layer 18 does not extend into the peripheral extension area 30 as illustrated in figure 2H. Then as illustrated in figure 2I, the stack is covered by the further water barrier layer 17 of the second water protection layer 8. Step 62 of figure 3, the providing of the second water protection layer, is thereby finalized. In figure 2I, the stack that is formed of each of the layers illustrated in figures 2A-2I is generally indicated with reference numeral 32.

Reference is made to figure 3, wherein optional step 63 indicate that the releasing of the flexible electronic device 3 from the rigid support plate 2 does not have to be performed immediately after the stack 32 has been formed. As will be appreciated, in those cases wherein the flexible electronic device 3 will be used immediately for manufacturing an appliance (such as a television, tablet type computer or mobile phone), the flexible electronic device 3 may be released directly after the stack 32 has been created. In that case, optional step 63 may be skipped and the method may be continued immediately with step 66, the releasing of the flexible electronic device 3. However, in many applications the flexible electronic device may remain fixed to the rigid support plate 2, and the stack 32 may be transported or stored first, before being applied. The water mediated release method of the present invention allows the step of releasing the flexible electronic device package 40 to be performed outside a manufacturing environment. Due to the fact that the availability of water is sufficient for performing the last step 66 of the method of the present invention, an engineer or operator may perform the step of releasing of the flexible electronic device in any location desired.

The releasing of the flexible electronic device (step 66) is schematically illustrated in figures 2J, 2K and 2L. In figure 2J it is indicated that for releasing the flexible electronic device, a cut 27 is made in the peripheral extension area 30 which provides access to the nickel absorption layer 25. Next, as illustrated in figure 2K, the stack 32 is immersed in a bath 35 containing water 33. This allows the water 33 to penetrate through the cut 27 into the nickel layer 25 such as to dissolve the adhesive layer 25. In figure 2L, the flexible electronic device package 40 is peeled off from the rigid support plate 2. The peripheral extension area 30 enables to peal off the flexible electronic device 40 without requiring additional tools.

As will be appreciated, although the invention has been described with a reference to a specific example, the invention is not limited to the specific example provided. For example, the configuration of the first or second water protection layer may be different from the configuration illustrated in figure 1. A different configuration of the water protection layers will, naturally, require slightly different steps to be taken in comparison to the steps illustrated in figures 2C-2E and 2G-2I. Moreover, also the use of a polyimide (PI) layer 22 is indicated as optional.

The present invention is not limited to a specific type of flexible electronic device to be created, although it is noted that this method is particularly advantageous to the manufacturing of flexible electronic devices that contain OLEDs, in particular AMOLEDs. This is because these flexible electronic devices are highly prone to exposure to water, while the present invention provides a water mediated release method that prevents a flexible electronic display itself from being in contact with water.

The present invention has been described in terms of some specific embodiments thereof. It will be appreciated that the embodiments shown in the drawings and described herein are intended for illustrative purposes only, and are not by any manner or means intended to be restricted on the invention. The context of the invention discussed here is merely restricted by the scope of the appended claims.

## Claims

1. Method of manufacturing a flexible electronic device, the method comprising the steps of:
providing an adhesive layer onto a rigid support plate;
forming the flexible electronic device on the rigid support plate by:
providing a flexible substrate layer on the rigid support plate such as to fix the flexible substrate to the rigid support plate using the adhesive layer; and
providing one or more device layers onto the flexible substrate layer, such as to form said flexible electronic device comprising at least the flexible substrate layer and the one or more device layers; and
releasing the electronic device from the rigid support;
wherein the flexible electronic device comprises an organic light emitting diode, and wherein the adhesive layer comprises a layer of nickel, and wherein:
the step of forming of the flexible electronic device comprises interposing of the flexible electronic device between a first and a second water protection layer; and
the step of releasing the electronic device comprises immersing the rigid support plate including the flexible electronic device in water such as to allow the water to penetrate into the nickel layer for releasing the flexible electronic device.

2. Method according to claim 1, wherein said interposing comprises prior to said step of providing the flexible substrate layer, providing the first water protection layer on the rigid support plate fixed thereto using the adhesive layer, and subsequent to said forming of said electronic device, providing the second water protection layer on the electronic device.

3. Method according to claims 1 or 2, wherein at least one or both of the first and second water protection layers are provided comprising two or more water barrier layers.

4. Method according to claim 3, wherein one or more or all of said water barrier layers are provided comprising silicon nitride (SiNₓ), aluminum oxide (AlOₓ), aluminum oxynitride (AlOₓN_{y}), silicon oxide (SiOₓ).

5. Method according to claim 3 or 4, wherein at least one or both of the first and second water protection layers are provided comprising an absorption layer interposed between at least two water barrier layers.

6. Method according to claim 5, wherein the absorption layer is provided comprising at least one of a group comprising a polyacrylate, CaO nanoparticles, a zeolite, a molecular getter.

7. Method according to any of the previous claims, wherein the first and second water protection layers are provided comprising a peripheral extension area extending beyond an area wherein the flexible electronic device is interposed between the water protection layers for sealing the electronic device between the water protection layers.

8. Method according to claim 7, wherein the peripheral extension area extends beyond the nickel layer on the rigid support plate, such as to seal the nickel layer during said manufacturing.

9. Method according to claim 7 or 8, and at least one of claims 5 or 6, wherein the absorption layer is provided such as to interpose between the water barrier layers in an area enclosed by the peripheral extension areas.

10. Method according to any of the claims 7-9, wherein the water barrier layers of said first or second water protection layers are contiguous in said peripheral extension areas such as to seal the absorption layer.

11. Method according to any of the claims 7-10, wherein the step of releasing the flexible electronic device from the rigid support plate comprises, prior to said immersing, breaking the water protection layers in the peripheral extension areas such as to provide access to the nickel layer for allowing the water to penetrate the nickel layer during said immersing.

12. Method according to any of the previous claims, wherein the flexible electronic device is an active matrix organic light emitting diode.

13. Apparatus for manufacturing a flexible electronic device using a method according to any of the previous claims, comprising
a layer deposition stage for providing an adhesive layer onto a rigid support plate, the adhesive layer comprising a nickel layer;
a device manufacturing stage for forming the flexible electronic device on the rigid support plate by depositing a first water protection layer onto the rigid support plate fixed using the adhesive layer, depositing a flexible substrate layer on the first water protection layer, forming one or more device layers onto the flexible substrate layer, and depositing a second water protection layer covering the one or more device layers; and
a device release stage for removing the electronic device from the rigid support, wherein device release stage comprises an immersion bath for immersing the rigid support plate including the flexible electronic device in water such as to allow the water to penetrate into the nickel layer for releasing the flexible electronic device.

14. Flexible electronic device manufactured using a method according to any of the claims 1-12, or manufactured using an apparatus in accordance with claim 13.

15. Flexible electronic device according to claim 14, wherein the flexible electronic device is an active matrix organic light emitting diode.
